**Europäisches Patentamt**

**European Patent Office**

**Office européen des brevets**

(19)

(11) **EP 1 229 570 A1**

## EUROPEAN PATENT APPLICATION
published in accordance with Art. 158(3) EPC

(12)

(43) Date of publication:
**07.08.2002 Bulletin 2002/32**

(21) Application number: **01938699.4**

(22) Date of filing: **15.06.2001**

(51) Int Cl.⁷: **H01L 21/02**, H05B 3/10,
H05B 3/16, H05B 3/18,
H05B 3/20, H01L 21/66

(86) International application number:
**PCT/JP01/05139**

(87) International publication number:
**WO 01/97263 (20.12.2001 Gazette 2001/51)**

(84) Designated Contracting States:
**AT BE CH CY DE DK ES FI FR GB GR IE IT LI LU
MC NL PT SE TR**

(30) Priority: **15.06.2000 JP 2000180321**

(71) Applicant: **IBIDEN CO., LTD.
Ogaki-shi Gifu-ken 503-0917 (JP)**

(72) Inventors:
• **HIRAMATSU, Yasuji, c/o IBIDEN CO., LTD
Ibi-gun, Gifu 501-0695 (JP)**
• **ITO, Yasutaka, c/o IBIDEN CO., LTD
Ibi-gun, Gifu 501-0695 (JP)**

(74) Representative: **Gillard, Marie-Louise et al
Cabinet Beau de Loménie
158, rue de l'Université
75340 Paris Cédex 07 (FR)**

(54) **HOT PLATE**

(57) An object of the present invention is to provide a hot plate in which a transmittance of a ceramic substrate is not more than 10%, thereby measuring a temperature of a heating face by a thermoviewer more accurately, and the present invention is a hot plate comprising a ceramic substrate and a conductor layer formed on a surface of said ceramic substrate or inside said ceramic substrate, wherein a transmittance of an infrared ray wavelength, of said substrate, is 0% or not more than 10%.

Fig. 2

EP 1 229 570 A1

**Description**

Technical Field

The present invention relates to a hot plate mainly used for a semiconductor producing/examining device.

Background Art

In a semiconductor producing/examining device and the like such as an etching device and a chemical vapor deposition device, there has conventionally been used a heater, a wafer prober and the like in which a base material made of metal such as stainless steel, aluminum alloy is used.
However, such a conventional heater made of metal as describe above has following problems.
First, since the heater plate is made of metal, the thickness thereof has to be approximately 1.5mm. The reason is that thin metal plate generates warping, strain and the like by thermal expansion due to heating, so that the silicon wafer placed on the metal plate may be damaged or inclined. However, there has been a problem that, when the heater plate is made too thick, the heater becomes too heavy and bulky.
Moreover, by changing a voltage or current amount applying to a resistance heating element, a temperature of a face (hereinafter, referred to as a heating face) for heating an object to be heated, such as a silicon wafer and the like. However, since the metal plate has a large thickness, there has been a problem that the temperature of the heater plate does not rapidly follow the change of the voltage or the current amount and the temperature cannot be easily controlled.
Thus, JP Kokai Hei 11-40330 proposes a hot plate in which a nitride ceramic or a carbide ceramic having high heat conductivity and strength is used as a substrate and a resistance heating element is provided on a surface of the plate-formed body made of such a ceramic (i.e., the ceramic substrate) by sintering metal particles on the substrate surface.
Further, JP Kokai Hei 9-48668 discloses an aluminumnitride sintered body containing carbon.

Summary of the Invention

However, in a ceramic substrate as described above, when a temperature of a surface thereof on which an object to be heated such as a silicon wafer is heated (hereinafter, referred to as a heating face) is measured by a thermoviewer, infrared ray emitted from the heating element is likely to be measured since infrared ray tends to penetrate the ceramic substrate, so that there has been a problem that the temperature at the heating face cannot be measured accurately.
The inventors of the present invention have found out, as a result of the assiduous study for solving the above-mentioned problems, that a ceramic substrate having infrared ray transmittance of 0% or not more than 10% can be produced by incorporating a given amount of carbon in the ceramic substrate, that is, specifically :by degreasing and firing a raw formed body which is made by pressurizing and forming a ceramic powder and a resin, thus decreasing the crystallinity of the carbon and increasing the efficiency of absorbance of infrared ray; or by selecting a resin which is more likely to remain as carbon with low crystallinity in the degreasing process, so that the present invention has been completed.
In short, the present invention is a hot plate comprising a ceramic substrate and a conductor layer formed on a surface of the ceramic substrate or inside the ceramic substrate,
    wherein a transmittance of an infrared ray wavelength of 2500 nm, of the ceramic substrate, is 0% or not more than 10%, and desirably a brightness of the ceramic substrate based on JIS Z 8721 is not more than N6.
According to the hot plate of the present invention, since the transmittance of infrared ray i.e., infrared ray having a wavelength of 2500nm is 10% or less, the ceramic substrate does not transmit the infrared ray emitted from the heating element, and the infrared ray from the heating element does not disturb the measurement when the surface temperature of the heating face of the hot plate is measured by the thermoviewer. Thus, a wavelength for measurement of the thermoviewer can be set from around 2500nm, and the infrared ray having a comparatively short wavelength generating at a low temperature can be captured for the measurement, thus a temperature of the heating face can be measured in a wider range from low temperature to high temperature.
Further, the brightness based on JIS Z 8721 is not more than N6 so that the ceramic substrate is blackened, thus by utilizing black body radiation and obtaining a high radiation heat, the ceramic substrate can be efficiently heated by the resistance heating element and the like. In addition, if the resistance heating element is formed inside the ceramic substrate, the resistance heating element can be shielded.

Brief Description of Drawings

Fig. 1 is a bottom view which schematically shows one example of a hot plate of the present invention.
Fig. 2 is a partially-enlarged sectional view which schematically shows a part of the hot plate shown in Fig. 1.
Fig. 3 is a partially-enlarged sectional view which schematically shows another example of the hot plate of the present invention.
Fig. 4 is a sectional view which schematically shows a supporting case in which the hot plate is fitted.
Figs. 5(a) to 5(d) are sectional views which schematically show a part of manufacturing processes of the hot plate of the present invention.
Figs. 6(a) to 6(d) are sectional views which schematically show a part of manufacturing processes of the hot plate of the present invention.
Fig. 7 is a chart which shows the absorption rate for each wavelength of the ceramic substrate obtained in example 1.
Fig. 8 is a chart which shows the absorption rate for each wavelength of the ceramic substrate obtained in comparative example 1.

Explanation of numerals

| 10 | Hot plate |
| 11, 21 | Ceramic substrate |
| 11a | Heating face |
| 11b, 12b | Bottom surface |
| 12(12a to 12d), 22 | Resistance heating element |
| 13 | End portion |
| 14 | Bottomed hole |
| 15 | Through hole |
| 16 | Lifter pin |
| 17 | External terminal |
| 18 | Temperature measuring element |
| 19 | Silicon wafer |
| 23 | External terminal |
| 24 | Brazing-filler |
| 27 | Blind hole |
| 28 | Conductor-filled through hole |
| 30 | Supporting case |
| 32 | Guide pipe |
| 35 | Heat insulator |
| 37 | Holding metal member |
| 38 | Bolt |
| 39 | Coolant introducing pipe |

Disclosure of the Invention

An embodiment of a hot plate according to the present invention will be described hereinafter.

The hot plate of the present invention is a hot plate comprising a ceramic substrate and a conductor layer formed on a surface of the ceramic substrate or inside the ceramic substrate, wherein a transmittance of an infrared ray wavelength, of the above-mentioned ceramic substrate, is 0% or not more than 10%.

The infrared ray wavelength to be measured may be selected from a range of 760 to 2600nm, but desirably is 2500nm. Since the wavelength is in an intermediate region between a near infrared region (760 to 2500nm) and an intermediate infrared region (2500 to 25000nm), it serves as a standard of transmittance of both infrared ray regions.

Moreover, the near infrared ray tends to be generated at a relatively low temperature, however, by curbing the transmittance of the near infrared ray region to not more than 10%, a temperature of a heating face, which ranges from a low temperature to a high temperature (100 to 800°C), can be measured by a thermoviewer more accurately.

The reason why the infrared ray transmittance of the ceramic substrate is reduced to 0 or not more than 10% is that, in the case that the transmittance is over 10%, the infrared ray emitted from the heating element affects the measurement by acting as background, whereby the measurement of the temperature in the heating face can no longer be performed accurately and the measured values exhibit errors. Here, such inaccurate data could be brought into an usable state by assuming such errors and correcting the data with reference to the assumed errors. However, a specific software for conducting the correction and complicated tasks would be necessitated in this case and such a hot plate is not satisfactory in the practical terms. Therefore, the transmittance of the ceramic substrate is most preferably not more than 5%.

Note that the above-mentioned transmittance is a value in a case of measuring an optical transmittance of a ceramic substrate having a thickness of 0.5mm.

Moreover, a brightness of the ceramic substrate is preferably not more than N6 when the brightness is measured according to the prescription of JIS Z 8721, because the ceramic substrate having a brightness of such a degree exhibits excellent heat radiation and shielding property. Further, in the ceramic substrate having such properties, the temperature at the surface thereof can be accurately measured by using a thermoviewer and thus the temperature of the face of the ceramic substrate, for heating a silicon wafer and the like (heating face) , can be easily controlled.

Here, N of the brightness is specifically indicated by the symbols N0 to N10, which represent ten gradient colors of a specific color. These ten gradient colors are obtained by: setting the brightness of ideal black at 0 and that of ideal white at 10; dividing the brightness range of the specific color into ten sections between the brightness of black and that of white in a manner that the difference in brightness perceived between adjacent sections becomes equal; and allocating the symbols N0 to N10 in this order to the obtained sections as the gradient colors.

The actual measurement of the brightness is carried out by comparing the sample with color cards corresponding to N0 to N10. In the measurement, the number of the first decimal fraction is set at 0 or 5.

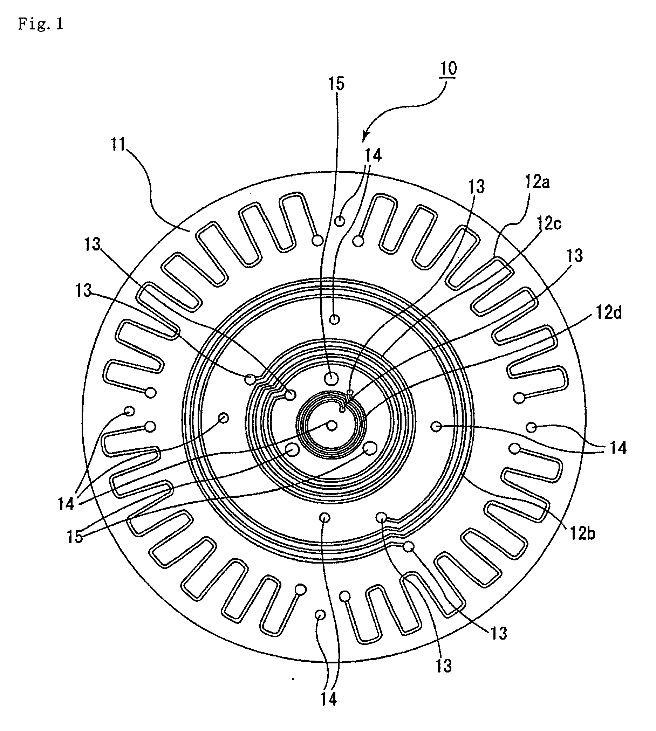

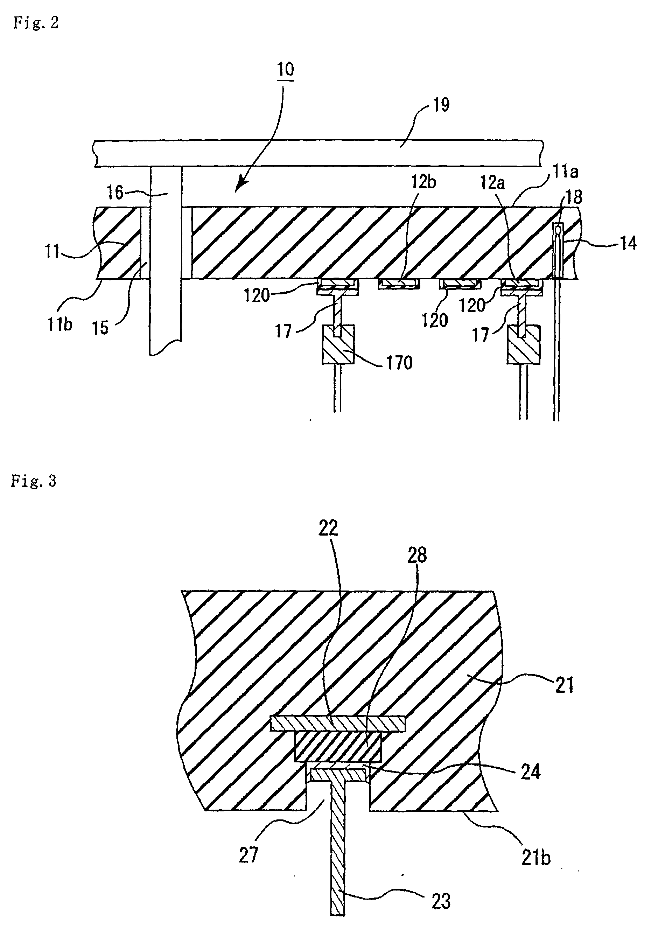

Fig. 1 is a bottom view which schematically shows one example of a hot plate of the present invention, and Fig. 2 is a partially-enlarged sectional view which schematically shows a part of the hot plate shown in Fig. 1. In the hot plate of Fig. 1, a resistance heating element is formed on the bottom face of the ceramic substrate.

As shown in Fig. 1, a ceramic substrate 11 is formed so as to have a disc shape, and at a bottom face 11b of the ceramic substrate 11, a resistance heating element 12a is formed in the vicinity of the peripheral portion of the bottom face and resistance heating elements 12b to 12d are formed at the portion radially inner side of the resistance heating element 12a. The resistance heating element 12a is composed of a winding circuit as shown in Fig. 1. The resistance heating elements 12b to 12d are composed of circuits having a configuration of substantially concentric circles. The ceramic substrate 11 is designed, by combining the above-mentioned circuits, so that the temperature distribution at the heating face 11a is made even.

A metal covering layer 120 is provided on each of the resistance heating elements 12a to 12d, so that the resistance heating elements are prevented from being oxidized. An end portion 13 for input/output is formed at each end of the resistance heating elements 12a to 12d. Further, an external terminal 17 is connected to the end portion 13 by solder, as shown in Fig. 2 . A socket 170 equipped with wiring is connected to the external terminal 17, whereby the external terminal 17 is connected to a powder source.

A bottomed hole 14 in which a temperature measuring element 18 is to be inserted is formed at the ceramic substrate 11. A through hole 15 through which a lifter pin 16 is to be inserted is formed at a portion near to the center of the ceramic substrate 11.

The lifter pin 16 is designed so that the lifter pin 16 can be moved in the vertical direction with carrying a silicon wafer 19 put thereon. By moving the lifter pin 16 in the vertical direction, the silicon wafer 19 can be transferred to a carrier machine (not shown) or the silicon wafer 19 can be received from a carrier machine. Further: the silicon wafer 19 can be set on a heating face 11a of the ceramic substrate 11 so that the silicon wafer 19 is heated; or the silicon wafer 19 can be supported in a state that the silicon wafer 19 is distanced by the length of 50 to 2000μm from the heating face 11a; so that the silicon wafer 19 can be heated.

Alternatively, it is acceptable that the silicon wafer 19 is heated in a state that the silicon wafer 19 is distanced by the length of 50 to 2000μm from the heating face 11a by: forming a through hole or a concave portion in the ceramic substrate 11; inserting a supporting pin having a tip end shaped in a form of aspire or semisphere into the through hole or the concave portion; fixedly holding the supporting pin in a state that the supporting pin is slightly projected from the ceramic substrate 11; and supporting the silicon wafer 19 by the supporting pin.

Fig. 3 is a partially-enlarged sectional view which schematically shows another example of the hot plate of the present invention. In the case of the hot plate shown in Fig. 3, the resistance heating element is formed inside the ceramic substrate.

A ceramic substrate 21 is formed so as to have a disc shape (not shown) in a manner similar to that of the ceramic heater shown in Fig. 1. A resistance heating element 22 is formed inside the ceramic substrate 21, in the pattern of the combination of concentric circles and winding lines i.e., in the pattern similar to that shown in Fig. 1.

A conductor-filled through hole 28 is formed right under the end portion of the resistance heating element 22. A blind hole 27 is formed on the bottom face 21b of the ceramic substrate 21 such that the conductor-filled through hole 28 is exposed outside. An external terminal 23 is inserted in the blind hole 27 and connected thereto by using a brazing-filler 24 and the like.

Although not shown in Fig. 3, a socket having a conductive wire, for example, is connected to the external terminal 23 in a manner similar to that in the hot plate shown in Fig. 1. The conductive wire is connected to a power source and the like.

The hot plate of the present invention has a structure shown in each of Figs. 1 to 3, for example. Each of the members which compose the above-mentioned hot plate, and the like, will be described one by one in detail hereinafter.

The ceramic material composing the above-mentioned hot plate is not particularly restricted. Examples of the ceramic material include nitride ceramic, carbide ceramic, oxide ceramic and the like.

Examples of the nitride ceramic include metal nitride ceramic such as aluminum nitride, silicon nitride, boronnitride, titanium nitride and the like.

Examples of the carbide ceramic include metal carbide ceramic such as silicon carbide, zirconium carbide, titanium carbide, tantalum carbide, tungsten carbide and the like.

Examples of the oxide ceramic include metal oxide ceramic such as alumina, zirconia, cordierite, mullite and the like.

These ceramics may be used singly or as a combination of 2 or more.

Among these examples, nitride ceramic and carbide ceramic are more preferable than oxide ceramic, because the heat conductivity of the nitride and carbide ceramics are higher than that of the oxide ceramic.

Among the above-mentioned examples of the nitride ceramic, the aluminum nitride is the most preferable because the heat conductivity thereof is the highest (180W/m·K).

In general, it is preferable that the nitride ceramic contains a metal oxide. The metal oxide acts as a sintering aid and thus facilitates the sintering process and reduces the size of the pore present inside the ceramic substrate, whereby the breakdown voltage, the mechanical properties and the like of the ceramic substrate are improved.

Examples of the metal oxide include yttria ($Y_2O_3$), alumina ($Al_2O_3$), rubidium oxide ($Rb_2O$), lithium oxide ($Li_2O$), calcium oxide ($CaCO_3$) and the like.

The preferable content of the metal oxide in the nitride ceramic is 1 to 10 parts by weight with respect to 100 parts by weight of the nitride ceramic.

In the ceramic substrate which constitutes the hot plate of the present invention, the infrared ray transmittance is reduced to 0 or not more than 10% and the brightness thereof is not more than N6 when evaluated as the value according to the prescription of JIS Z 8721.

A ceramic substrate having such properties as described above can be obtained by adding carbon to the ceramic substrate so that the carbon content therein is in a range of 100 to 5000ppm. The carbon has two types: amorphous one and crystalline one. When amorphous carbon is used, the decrease in the volume resistivity of the ceramic substrate at a high temperature can be suppressed. In addition, amorphous carbon is likely to absorb rays in the infrared region and does not allow such infrared rays to transmit the ceramic substrate. Therefore, amorphous carbon is more advantageously used than crystalline carbon.

Amorphous carbon can be obtained, for example, by firing in the air a hydrocarbon (preferably a saccharide) which is composed of only C, H and O. Examples of crystalline carbon includes graphite powder and the like.

Alternatively, a ceramic substrate containing carbon can be obtained by heat-decomposing a green sheet lamination and the like which contains an acrylic resin in an inactive atmosphere and then heating and pressurizing the product. The degree of crystallinity (or amorphousness) can be adjusted by changing the acid value of the acrylic resin. The above-mentioned acrylic resin may be added as a binder.

As the above-mentioned acrylic resin binder, the SA-545 series manufactured by Mitsui Chemicals Co., Ltd., or the KC-600 series manufactured by Kyoeisha Co., Ltd., for example, and the like can be used.

It is preferable that the porosity of the above-mentioned ceramic substrate is not more than 5% and the diameter of the largest pore in the ceramic substrate is not more than 50μm.

When the above-mentioned porosity exceeds 5%, the number of the pore present in the ceramic dielectric film increases and pore diameter becomes larger. A ceramic substrate having such a structure is likely to suffer from deterioration of the breakdown voltage and the mechanical properties.

When the diameter of the largest pore exceeds 50μm, deterioration of the breakdown voltage and the mechanical properties are also likely to occur to the ceramic substrate.

The porosity of the ceramic substrate is preferably 0 or not more than 3%. The diameter of the largest pore of the ceramic substrate is preferably 0 or not more than 10μm.

The measurement of the pore diameter of the largest pore is performed by: preparing five samples and polishing the surface thereof into mirror planes; photographing the surface of each sample at ten sites by an electron microscope with 2000 to 5000 magnification; selecting the largest pore diameter from each shot; and regarding the average of the largest pore diameter of the 50 shots as the pore diameter of the largest pore.

The above-mentioned porosity is measured by the Archimedes' method. This method includes the steps of:

pulverizing the sintered body and putting the pulverized sample into an organic solvent or mercury, to measure the volume thereof; obtaining the true specific gravity from the weight of the pulverized sample and the volume thereof; and calculating the porosity from the obtained true specific gravity and the apparent specific gravity.

The hot plate of the present invention is generally provided with a resistance heating element as shown in Fig. 1. Examples of the above-mentioned temperature controlling means include a Peltier device, in addition to the resistance heating element.

In a case that the resistance heating element is provided inside the ceramic substrate, plural layers of the resistance heating element may be provided therein. In this case, it is preferable that the patterns at the layers are designed so that the patterns complement each other, whereby any portion thereof is covered by one of these patterns or layers without leaving any uncovered portion when viewed from the top of the heating face. For example, a structure having a staggered arrangement may be used.

Examples of the resistance heating element include a sintered body of metal or electrically conductive ceramic, a metal foil, a metal wire and the like. As the metal sintered body, a metal sintered body which is composed of at least one type selected from tungsten and molybdenum is preferable, because these metals are relatively less likely to be oxidized and have a sufficient resistance value for generating heat.

As the conductive ceramic, at least one type selected from carbides of tungsten and molybdenum may be used.

Further, in a case that the resistance heating element is formed at the bottom face of the ceramic substrate, it is preferable to use noblemental (gold, silver, palladium, platinum) or nickel as the metal sintered body. Specifically, silver, silver-palladium and the like can be preferably used.

The shape of the metal particles used for producing the metal sintered body may be either spherical or scaly. Alternatively, both spherical particles and scaly particles may be used in a mixed manner.

A metal oxide may be added to the metal sintered body. The metal oxide is used in order to adhere the metal particles to the ceramic substrate. The reason why the metal oxide improves the adhesion of the metal particles to the ceramic substrate is not clearly known. A thin oxidized film is formed on the surface of the metal particle, and an oxidized film is also formed on the surface of the ceramic substrate, regardless of whether the ceramic substrate is oxide ceramic or non-oxide ceramic. It is thus assumed that the oxidized film of the metal particle and that of the ceramic substrate are integrated to one film when these oxidized films are sintered at the surface of the ceramic substrate by way of the metal oxide, whereby the metal particles tightly adhere to the ceramic substrate.

As the metal oxide, at least one type of compound selected from the group consisting of lead oxide, zinc oxide, silica, boron oxide ($B_2O_3$), alumina, yttria and titania is preferably used, because these oxides can improve adhesion of the metal particles to the ceramic substrate without increasing the resistance value of the resistance heating element.

The content of the metal oxide is preferably in a range of 0.1 or more and less than 10 parts by weight with respect to 100 parts by weight of the metal particles. By using the metal oxide within the above-mentioned range, the adhesion between the metal particles and the ceramic substrate can be enhanced without increasing the resistance value too much.

The contents of lead oxide, zinc oxide, silica, boron oxide ($B_2O_3$), alumina, yttria and titania are preferably 1 to 10 parts by weight in lead oxide, 1 to 30 parts by weight in silica, 5 to 50 parts by weight in boron oxide, 20 to 70 parts by weight in zinc oxide, 1 to 10 parts by weight in alumina, 1 to 50 parts by weight in yttria and 10 to 50 parts by weight in titania, with respect to the whole weight of the metal oxides expressed as 100 parts by weight. It is preferable that these contents of the metal oxides are adjusted so that the total sum of the metal oxides does not exceed 100 parts by weight, because these metal oxides can especially enhance adhesion to the ceramic substrate in such a range.

In a case that the resistance heating element is provided at the bottom face of the ceramic substrate, the surface of the resistance heating element 12 is preferably covered with a metal covering layer 120 (refer to Fig. 2). As the resistance heating element 12 is a sintered body of metal particles, the resistance heating element 12 is easily oxidized if it is exposed in the air, and the resistance value thereof changes due to the oxidization. By covering the surface of the resistance heating element 12 with a metal covering layer 120, such oxidization can be prevented.

The thickness of the metal covering layer 120 is preferably in a range of 0.1 to 10μm. When the thickness of the metal covering layer 120 is within this range, the oxidization of the resistance heating element can be prevented without changing the resistance value of the resistance heating element too much.

The metal used for the metal covering layer is not particularly limited, as long as the metal is non-oxidizable. Specific examples thereof include at least one type of metal selected from the group consisting of gold, silver, palladium, platinum and nickel. Among these examples, nickel is the most preferable. The resistance heating element requires a terminal for performing connection of the resistance heating element to the power source, and this terminal is attached to the resistance heating element through solder. Nickel effectively prevents the heat dissipation due to solder. As the connection terminal, a terminal pin made of Kovar can be used.

In a case that the resistance heating element is formed inside the heater plate, the surface of the resistance heating element is not oxidized and thus no covering by the metal layer is required. When the resistance heating element is formed inside the heater plate, a portion of the surface of the resistance heating element may be exposed outside of the heater plate.

Preferable examples of the metal foil used as the resistance heating element include a resistance heating element produced by a pattern-forming process, such as etching and the like, of nickel foil or stainless foil.

The metal foils which have been subjected to the pattern-forming process may be laminated with a resin film and the like.

Example of the metal wire include a tungsten wire, a molybdenum wire and the like.

In a case that a Peltier device is used as the temperature controlling means, either heating or cooling can be performed by the same element by changing the flow direction of the current, which is advantageous.

The Peltier device is formed by connecting p-type and n-type thermoelectric elements in series and attaching these thermoelectric elements to the ceramic plate and the like.

Examples of the Peltier device include the silicon/germanium-based Peltier device, the bismuth/antimony-based Peltier device, the lead/tellurium-based Peltier device and the like.

In the hot plate of the present invention, when the resistance heating element 22 is formed inside the ceramic substrate, a connecting unit (a conductor-filled through hole) 28 for performing connection of the resistance heating element 22 to the external terminal is required. The conductor-filled through hole 28 is formed by filling a metal having a high melting point such as tungsten paste and molybdenum paste or a conductive ceramic such as tungsten carbide and molybdenum carbide.

Here, the diameter of the connecting unit (a conductor-filled through holes) 28 is preferably in a range of 0.1 to 10mm, because when the diameter of the connection portion is within this range, not only disconnection of the wire but also generation of cracks or strains can be reliably prevented.

An external terminal pin 23 is connected thereto through the conductor-filled through hole as a connection pad (refer to Fig. 3).

The above-mentioned connection is carried out by using solder or brazing filler. As the brazing filler, silver braze, palladium braze, aluminum braze and gold braze are preferably used. As the gold braze, Au-Ni alloy is preferable because Au-Ni alloy exhibits excellent adhesion property with tungsten.

The ratio of Au/Ni is preferably [81.5 to 82.5 (% by weight)]/[18.5 to 17.5 (% by weight)].

The thickness of the Au-Ni layer is preferably in a range of 0.1 to 50$\mu$m, because the connection property is reliably obtained when the thickness of the Au-Ni layer is within this range. In the case of Au-Cu alloy, the alloy exhibits deterioration when used in a highly vacuumed state of $10^{-6}$ to $10^{-5}$Pa at a high temperature in a range of 500 to 1000°C. On the other hand, the Au-Ni alloy does not exhibit deterioration when the alloy is used in such a harsh condition, which is advantageous. The content of the impurity elements contained in the Au-Ni alloy is preferably less than 1 parts by weight when the whole weight of the Au-Ni alloy is expressed as 100 parts by weight.

In the present invention, a thermocouple may be embedded in the bottomed hole 12 of the ceramic substrate 1, according to the necessity. In such a structure, the temperature of the resistance heating element can be measured by the thermocouple, so that the temperature of the resistance heating element can be controlled by changing the magnitude of the voltage and the current on the basis of the obtained data.

The size of the connecting portion of the metal wire of the thermocouple is preferably the same as or larger than the strand diameter of each metal wire, but not more than 0.5mm. The heat capacity of the connecting portion is made small by such a structure, whereby the temperature is converted into the current value correctly and rapidly. As a result, the temperature controlling property is improved, whereby the temperature distribution at the heating face of the wafer is made small.

Examples of the aforementioned thermocouple include the K-type, the R-type, the B-type, the S-type, the E-type, the J-type and the T-type thermocouples, as is raised in JIS-C-1602 (1980).

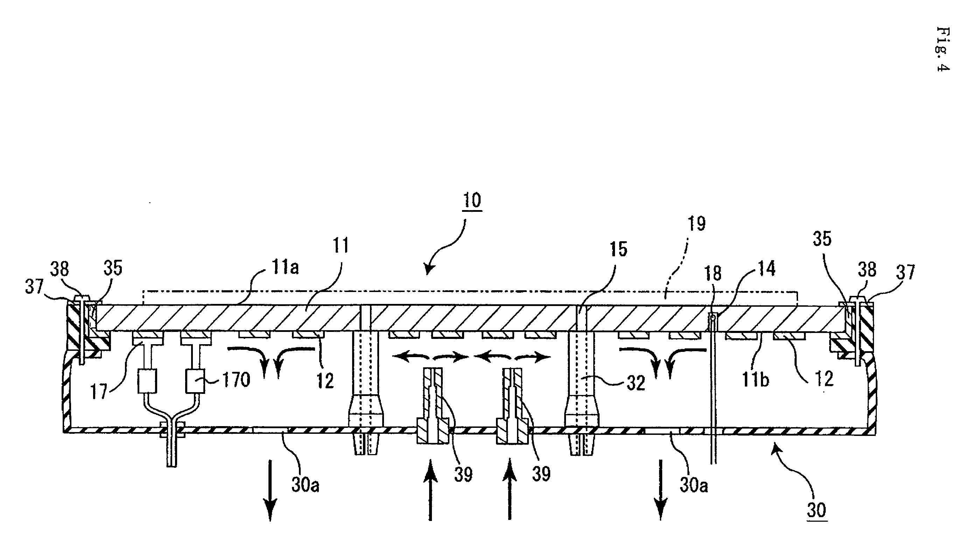

Fig. 4 is a sectional view which schematically shows a supporting case 30 in which the hot plate (the ceramic substrate) having a structure as described above is fitted.

The supporting case 30 is designed such that the ceramic substrate 11 is fitted therein through a heat insulator 35 and fixed thereto by a bolt 38 and a holding metal member 37. A guide pipe 32 is provided under the portion where the through hole 15 of the ceramic substrate 11 has been formed, so that the guide pipe 32 communicates with the through hole. Further, a coolant outlet 30a is formed in the supporting case 31 such that the coolant introduced from a coolant introducing pipe 39 is discharged outside from a coolant outlet 30a. By the action of the coolant, the ceramic substrate 11 can be cooled.

In the above-mentioned hot plate, the resistance heating element is substantially the only component provided on the surface of the ceramic substrate. By the action of the resistance heating element, the object to be heated such as a silicon wafer can be heated to a predetermined temperature.

The hot plate of the present invention is a device mainly used for production/inspection of a semiconductor, which includes as main components a ceramic substrate and a resistance heating element solely provided on the ceramic substrate. However, when electrostatic electrodes are provided inside the ceramic substrate, the device functions as an electrostatic chuck. When: a conductor layer is provided on the surface of the ceramic substrate; and a guard electrode and a ground electrode are provided inside the ceramic substrate, the device functions as a wafer prober.

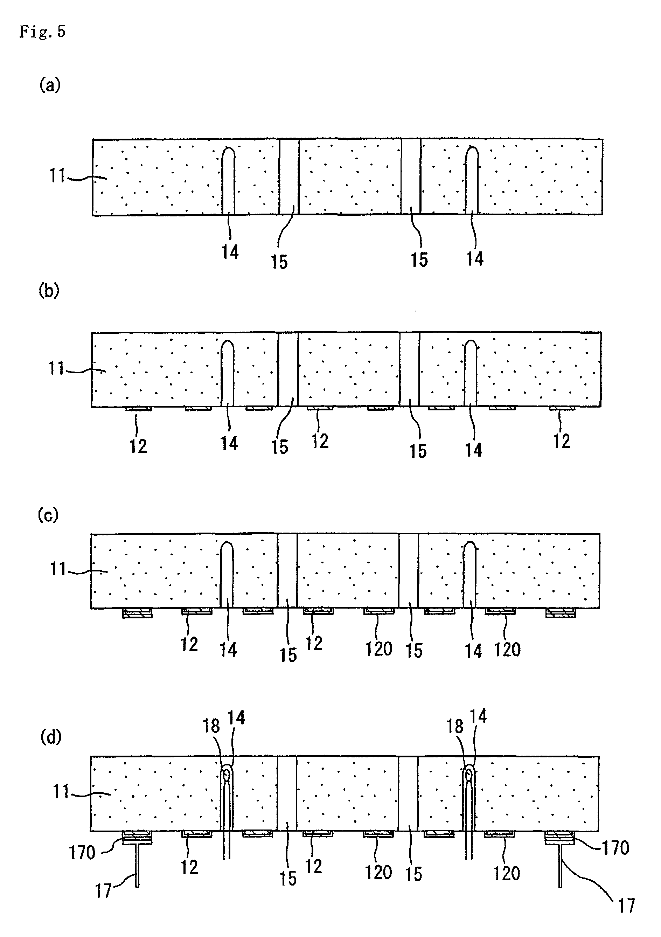

Next, a method of producing a hot plate in which a resistance heating element is formed on the bottom face thereof will be described with reference to Figs. 5(a) to 5(d).

(1) Manufacturing process of a ceramic substrate

The above-mentioned nitride ceramic such as aluminum nitride is blended with a sintering aid such as yttria, a binder and the like, according to necessity, whereby a slurry is prepared. The prepared slurry is granulated by an appropriate method such as spray drying and the like. The obtained granules are filled in a mold and the like and pressed for molding in a plate-shaped and the like, so that a raw formed body (green) is manufactured. An acrylic resin and the like which is likely to remain as carbon after sintering is generally used as a binder, so that the ceramic substrate has a preferable carbon content. An acrylic resin is advantageously employed in the present invention because the acrylic resin produces carbon with low-crystallinity as a result of thermal decomposition.

Next, the raw formed body is heated and fired to effect sintering, whereby a plate-formed body made of ceramic is manufactured. Thereafter, the ceramic substrate 11 is manufactureed by processing the plate-formed body into a predetermined shape. Alternatively, the plate-formed body may be produced such that the plate-formed body can be used as the ceramic substrate 11 after firing without any further processing. The ceramic substrate 11 having no pore can be manufactured by conducting heating and firing while applying a pressure. The temperature at which heating and firing are to be carried out is not particularly restricted as long as the temperature is not less than the sintering temperature. In the case of nitride ceramic, the preferable temperature range is 1000 to 2500°C.

Next, the through hole 15 through which the lifter pin 16 for transferring a silicon wafer is inserted, the bottomed hole 14 in which a temperature measuring element such as a thermocouple is embedded, a concave portion in which a supporting pin for supporting a silicon wafer is embedded, and the like are optionally formed in the ceramic substrate (Fig. 5(a)).

(2) Process for printing a conductor containing paste on the ceramic substrate

By preparing a conductor containing paste and printing the conductor containing paste on a ceramic substrate by screen printing and the like in the pattern of the heating element, a conductor containing paste layer is formed on the ceramic substrate. The resistance heating element is preferably printed in the pattern of the combination of concentric circles-like and winding lines-like as shown in Fig. 1, as the resistance heating element needs to have a design which allows even distribution of temperature over the whole ceramic substrate.

It is preferable that the conductor containing paste layer is formed such that the section of the resistance heating element 12 after firing has a quadrilateral, flat section.

(3) Firing of the conductor containing paste

The conductor containing paste layer printed at the bottom face of the ceramic substrate 11 is heated and fired, so that the resin and the solvent are removed therefrom and the noble metal particles are sintered. As a result of this sintering, the noble metal particles are baked on the bottom face of the ceramic substrate 11, whereby the resistance heating element 12 is formed (refer to Fig. 5(b)). The temperature during the heating and firing process is preferably in a range of 500 to 1000°C.

In a case that the above-mentioned metal oxide is added to the conductor containing paste, the noble metal particles, the metal oxide and the ceramic substrate are sintered and integrated with each other, whereby adhesion between the resistance heating element and the ceramic substrate is improved.

(4) Formation of the metal covering layer

Thereafter, a metal covering layer 120 is provided on the surface of the resistance heating element 12 (refer to Fig. 5(c)). The metal covering layer 120 can be formed by electrolytic plating, electroless plating, spattering and the like. Among these methods, electroless plating is the most preferable in terms of achieving high productivity.

(5) Attaching of the terminals and the like

External terminals 13 for performing connection of the resistance heating element to the power source are attached to the end portions of the pattern of the resistance heating element 12 by using solder and the like. A temperature measuring element (thermocouple) 18 is inserted in the bottomed hole 14 and the bottomed hole 14 is sealed by using a ceramic or a heat resistant resin such as polyimide and the like, whereby a hot plate 10 is manufactured (refer to Fig. 5(d)).

In the manufacturing process of the above-mentioned hot plate, an electrostatic chuck can be manufactured by providing electrostatic electrodes inside the ceramic substrate, and a wafer prober can be manufactured by providing a chuck top conductor layer at the heating face of the ceramic substrate and also providing a guard electrode and a ground electrode inside the ceramic substrate.

Equipment of electrodes inside the ceramic substrate can be achieved by embedding a metal foil and the like inside the ceramic substrate. A conductor layer can be formed at the surface of the ceramic substrate by using the spattering method or the plating method or employing both of the two methods.

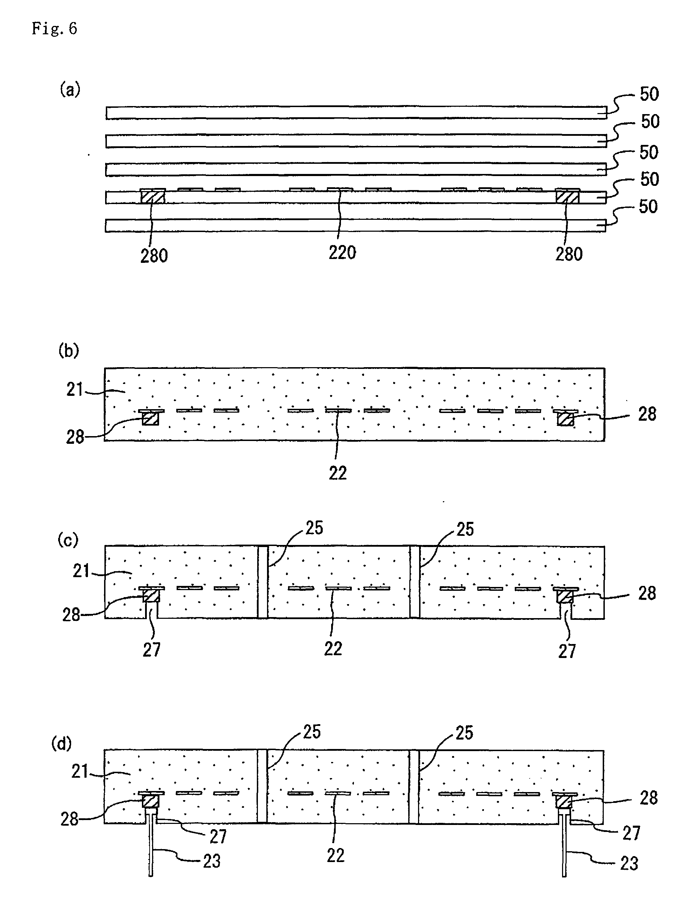

Next, a method of manufacturing a hot plate including a resistance heating element formed inside a ceramic substrate will be described with reference to Figs. 6(a) to 6(d).

(1) Process of manufacturing a green sheet

First, a paste is prepared by mixing nitride ceramic powder with a binder, a solvent and the like. A green sheet is then manufactured by using the paste.

As the above-mentioned ceramic powder, aluminum nitride and the like can be used. A sintering aid such as yttria may optionally be added to the ceramic powder. When a green sheet is manufactured, an acrylic resin and the like which is likely to remain as carbon after the sintering process is preferably used as a binder. However, amorphous carbon may be used instead of an acrylic resin.

As the binder, at least one type of binder selected from the group consisting of an acrylic binder, ethyl cellulose, butyl cellosolve and polyvinyl alcohol is preferably used.

As the solvent, at least one type of solvent selected from $\alpha$-terpineol and glycol is preferably used.

The paste obtained by mixing the above-mentioned Components is formed into a sheet shape by the doctor blade method, whereby a green sheet 50 is manufactured.

The thickness of the green sheet 50 is preferably in a 'range of 0.1 to 5mm.

Next, a portion which is to serve as the through hole through which the lifter pin for supporting a silicon wafer is inserted, a portion which is to serve as the through hole 25 through which the lifter pin for transferring a silicon wafer is inserted, a portion which is to serve as the bottomed hole in which a temperature measuring element such as a thermocouple is embedded, a portion 280 which is to serve as a conductor-filled through hole for performing connection of the resistance heating element to the external terminal, and the like are optionally formed in the obtained green sheet. The above-mentioned processing may be carried out after the formation of a green sheet lamination described hereinafter.

(2) Process of printing the conductor containing paste on the green sheet

The conductor containing paste is printed on the green sheet 50, whereby a conductor containing paste layer 220 is formed on the green sheet 50. Further, the conductor containing paste is filled at the portion which is to serve as the conductor-filled through hole.

The conductor containing paste contains metal particles or conductive ceramic particles. Examples of the material of the metal particles include tungsten, molybdenum and the like. Examples of the conductive ceramic include tungsten carbide and molybdenum carbide.

The average particle diameter of tungsten particles or molybdenum particles as the above-mentioned metal particles is preferably in a range of 0.1 to 5μm. When the average particle diameter thereof is less than 0.1μm or exceeds 5μm, the conductor containing paste may not be properly printed on the green sheet.

Examples of such conductor containing paste include a composite (paste) which is obtained by mixing: 85 to 87 parts by weight of metal particles or conductive ceramic particles; 1.5 to 10 parts by weight of at least one type of binder selected from the group consisting of an acrylic binder, ethyl cellulose, butyl cellosolve and polyvinyl alcohol; 1.5 to 10 parts by weight of at least one type of solvent selected from $\alpha$-terpineol and glycol.

(3) Process of laminating the green sheets

The green sheets 50 on which the conductor containing paste has not been printed, produced in the above-mentioned process (1), are laminated on the upper and lower faces of the green sheet 50 having the paste layer 220 and the like thereon manufactured in the above-mentioned process (2) (Fig. 6(a)).

Here, the number of the green sheet 50 laminated on the upper side of the green sheet having the paste layer 220 thereon is set larger than the number of the green sheet 50 laminated on the lower side of the green sheet 50 having the paste layer 220 thereon, so that the resistance heating element 22 is located in the lamination at a position closer to the bottom surface rather than the top surface of the lamination.

Specifically, the preferable number of the green sheet 50 laminated on the upper side of the green sheet having the paste later 220 is 20 to 50, and the preferable number of the green sheet 50 laminated on the lower side thereof is 5 to 20.

(4) Firing process of the green sheet lamination

The green sheet lamination is subjected to heating and pressurizing and the green sheet 50 and the conductor containing paste therein are sintered, whereby a ceramic substrate 31 is manufactured (Fig. 6(b)).

The temperature at which the green sheet lamination is heated is preferably in a range of 1000 to 2000°C. The pressure to be applied to the green sheet lamination is preferably in a range of 10 to 20MPa. The heating is carried out in an inert gas atmosphere. As the inert gas, argon, nitrogen and the like, for example, may be used.

A through hole 25 through which the lifter pin is inserted, the bottomed hole (not shown) in which a temperature measuring element is embedded, a blind hole 27 in which an external terminal 23 is inserted, and the like are formed in the obtained ceramic substrate 21 (Fig. 6(c)). The through hole 25, the bottomed hole and the blind hole 27 can be formed at the substrate surface, after the polishing of the substrate surface, by performing the drilling process or the blasting process such as sand blast and the like at the substrate surface.

Next, the external terminal 23 is connected to the conductor-filled through hole 28, which is exposed from the blind hole 27, by using gold brazing and the like (Fig. 6(d)). Further, a socket having conductive wires, for example, is detachably fitted to the external terminal 23 (not shown).

In the case that solder is used for the above-mentioned process, the temperature at which heating is carried out is preferably in a range of 90 to 450°C. In the case that brazing filler is used for the above-mentioned process, the temperature at which heating is carried out is preferably in a range of 900 to 1100°C. A thermocouple and the like as the temperature measuring element is sealed in the bottomed hole by using a heat resistant resin, whereby a ceramic heater is substantially produced.

(5) Thereafter, the ceramic substrate 21 having the resistance heating element 12 inside thereof is fitted in a supporting case of cylindrical shape, and the lead wire extending from the socket is connected to the power source, whereby the manufacturing of the ceramic heater is completed.

In the manufacturing process of the above-mentioned hot plate, an electrostatic chuck can be manufactured by providing electrostatic electrodes inside the ceramic substrate, and a wafer prober can be manufactured by providing a chuck top conductor layer at the heating face of the ceramic substrate and also providing a guard electrode and a ground electrode inside the ceramic substrate.

In the case that electrodes are provided inside the ceramic substrate, such a structure can be obtained by forming the conductor containing paste layer on the green sheet in the pattern of the electrostatic electrodes, a guard electrode and the like and performing the lamination and firing processes thereafter. In the case that the conductor layer is formed at the surface of the ceramic substrate, such a structure can be obtained by producing a ceramic substrate and then forming a conductor layer thereon according to the spattering or plating method. Here, the spattering method and the plating method may be used in a combined manner.

Best Mode for Carrying Out the Invention

(Example 1) manufacturing of a hot plate (Fig. 6)

(1) A paste was produced by mixing: 100 parts by weight of aluminum nitride powder (manufactured by Tokuyama co., the average particle diameter: 1.1μm); 4 parts by weight of yttria (the average particle diameter: 0.4μm); 10 parts by weight of acrylic resin binder ("SA-545" series having the acid value of 0.5, manufactured by Mitsui Chemicals Co., Ltd.,); 0.5 parts by weight of a dispersant; and 53 parts by weight of alcohol composed of 1-butanol and ethanol. By using the obtained paste and performing the molding process according to the doctor blade method, a green sheet having thickness of 0.47mm was obtained.

(2) Next, the green sheet was dried for five hours at 80°C. Thereafter, through holes having diameter of 1.8mm, 3.0mm and 5.0mm, respectively, were formed by punching, whereby portions for conductor-filled through holes for performing connection of the resistance heating element to an external terminal were provided.

(3) A conductor containing paste A was prepared by mixing: 100 parts by weight of tungsten carbide particles whose average particle diameter was 1μm; 3.0 parts by weight of an acrylic binder; 3.5 parts by weight of α-terpineol; 0.3 parts by weight of a dispersant.

A conductor containing paste B was prepared by mixing: 100 parts by weight of tungsten particles whose average particle diameter was 3μm; 1.9 parts by weight of an acrylic binder; 3.7 parts by weight of α-terpineol; 0.2 parts by weight of a dispersant.

The conductor containing paste A was printed on a green sheet by screen printing, whereby a conductor containing paste layer for a resistance heating element was formed. The printing pattern was a concentric circle-like pattern.

The conductor containing paste B was filled in the through holes provided to be the conductor-filled through holes for performing connection of the resistance heating element to the external terminal.

The green sheet 50 which had been subjected to the above-mentioned treatment was laminated with 34 sheets provided at the upper side thereof (heating face) and 13 sheets provided at the lower side thereof, those are the green sheet 50 on which the tungsten paste had not been printed, at 130°C and at a pressure of 8MPa (80kgf/cm$^2$), whereby a lamination was formed (Fig. 6 (a)).

(4) Next, the obtained lamination was degreased in nitrogen gas at 600°C for 10 hours and then hot-pressed for 3 hours at 1890°C and at a pressure of 15MPa (150kgf/cm$^2$), whereby a plate-formed body of aluminum nitride having thickness of 3mm was obtained. This plate-formed body of aluminum nitride was cut out so as to have a disc shape having diameter of 230mm, whereby a plate-formed body made of aluminum nitride (a ceramic substrate 21) having a resistance heating element 22 (thickness: 6μm and width: 10mm) inside thereof was obtained (Fig. 6(b)).

The crystallinity of carbon contained in the ceramic substrate 21 was analyzed by using laser Raman spectrum. Peaks were observed at 1580cm$^{-1}$ and 1355cm$^{-1}$. The peak at 1355cm$^{-1}$ indicates that carbon is amorphous i.e., carbon has low crystallinity.

(5) Next, the plate-formed body obtained in the aforementioned (4) was ground by using a diamond whetstone. Thereafter, a mask was set thereon and a bottomed hole (diameter: 1.2mm, depth: 2mm) in which a thermocouple was to be embedded and a through hole through which a lifter pin was to be inserted were formed at the surface of the plate-formed body by the blasting process using SiC and the like (Fig. 6(c)).

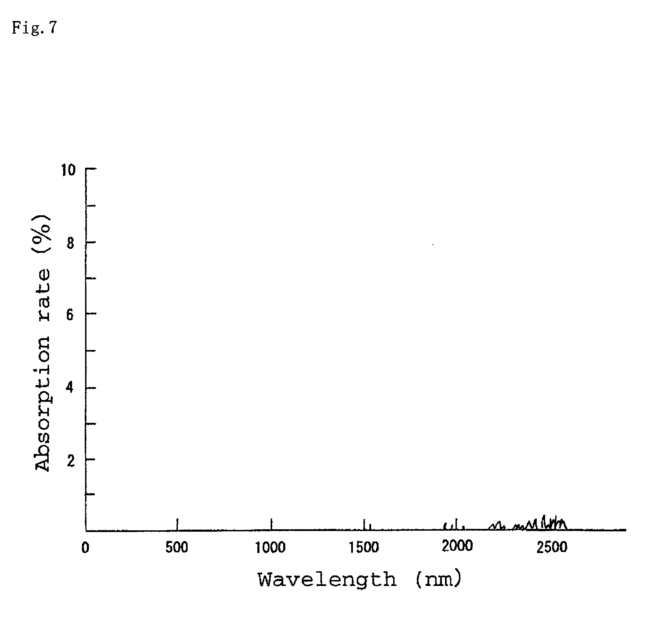

(6) Next, a blind hole 27 was formed by hollowing out a portion where the conductor-filled through hole had been formed (Fig. 7(c)). An external terminal 23 made of Kovar was connected to the blind hole 27 by using gold brazing of Ni-Au and performing heating and reflowing at 700°C (Fig. 7(d)).

It is preferable that the connection of the external terminals is effected by a structure wherein the external terminal is supported by the support of tungsten at three sites. The external terminals can be reliably connected to the blind holes in such a structure.

(7) Next, a plurality of thermocouples for controlling the temperature was embedded in the bottomed hole by using a resin such as polyimide and the like, whereby the manufacturing of a hot plate was completed.

(Example 2) Manufacturing of a hot plate (refer to Fig. 5)

(1) A composition was prepared by mixing: 100 parts by weight of aluminum nitride powder (manufactured by Tokuyama co., the average particle diameter: 1.1μm); 4 parts by weight of yttrium oxide ($Y_2O_3$, yttria, the average particle diameter: 0.4μm); 8 parts by weight of acrylic resin binder (KC-600™ series having the acid value of 17, manufactured by Kyoeisha Co., Ltd.,); and alcohol. By spray-drying the composition, granular powder was manufactured.

(2) Next, the granular powder was filled in a mold and formed so as to have a plate shape, whereby a raw formed body (green) was obtained.

(3) The plate-formed body which had been subjected to the processing treatment was then hot-pressed at 1800°C under a pressure of 20MPa, whereby an aluminum nitride sintered body of 3mm thickness was obtained.

Next, a disc-formed body having diameter of 310mm was cut out from the plate-formed body, whereby a plate-formed body made of ceramic (a ceramic substrate 11) was obtained (Fig. 5(a)).

Thereafter, the obtained plate-formed body was subjected to drilling, whereby a through hole 15 through which a lifter pin 16 for transferring a semiconductor wafer was to be inserted, a bottomed hole (diameter: 1.1mm, depth: 2mm) 14 in which a thermocouple was to be embedded, were formed.

(4) A conductor containing paste was printed, by screen printing, at the bottom surface of the sintered body obtained in the above-mentioned (3). The printing pattern was a pattern of the combination of concentric circles-like and winding lines-like as shown in Fig. 1.

As the conductor containing paste, "SOLVEST PS603D" manufactured by Tokuriki Kagaku Kenkyujo, which is used for forming a plated through hole of a printed circuit board, was employed.

The conductor containing paste was a silver-lead paste containing 7.5 parts by weight of a metal oxide with respect to 100 parts by weight of silver. The metal oxide was composed of: lead oxide (5% by weight) ; zinc oxide (55% by weight) ; silica (10% by weight); boron oxide (25% by weight); and alumina (5% by weight). The average particle diameter of the silver particles was 4.5μm and the shape of the silver particles was scaly.

(5) Next, the sintered body on which the conductor containing paste had been printed was heated at 780°C and fired so that the silver and lead in the conductor containing paste were sintered and baked on the sintered body, whereby the resistance heating element 12 was formed (Fig. 5(b)). The thickness, the width and the sheet resistivity of the silver-based resistance heating element 12, in the vicinity of the end portion thereof, were 5μm, 2.4mm and 7.7mΩ/□, respectively.

(6) The sintered body which had been produced in the aforementioned (4) was immersed in an electroless nickel plating bath containing aqueous solutions of nickel sulfate (80g/L), sodiumhypophosphite (24g/L), sodium acetate (12g/L), boric acid (8g/L) and ammonium chloride (6g/L), so that a metal covering layer (a nickel layer) 120 having thickness of 1μm was deposited on the surface of the silver-based resistance heating element 12 (Fig. 5(c)).

(7) A solder layer was formed by screen printing a silver-lead solder paste (manufactured by Tanaka Noble metal co.) at the end portion of the resistance heating element, so that the connection of the resistance heating element to the power source was reliably effected.

Next, an external terminal 13 having a T-shaped end portion was set on the solder layer and was subjected to heating and reflowing at 420°C, so that the external terminal 17 was fixed to the end portion of the resistance heating element 12 through the solder 170.

(8) A thermocouple for controlling the temperature was inserted in the bottomed hole 13. The bottomed hole 13 was filled with a polyimide resin. The resin was left at 190°C for two hours so that the resin was cured, whereby a hot plate 10 having a resistance heating element 12 at the bottom face 11b thereof was obtained.

(Examples 3 to 4) Manufacturing of a hot plate

In example 3, a hot plate was produced in a manner similar to that of example 2 except that 4 parts by weight of acrylic resin binder (KC-600™ series having the acid value of 17, manufactured by Kyoeisha Co., Ltd.,) was used. In examples 4, a hot plate was produced in a manner similar to that of example 2 except that 20 parts by weight of the same acrylic resin binder was used.

(Comparative Example 1)

Comparative example 1 was performed in a manner similar to that of example 1 except that the degreasing process was carried out at 600°C for 24 hours and the carbon content was reduced to approximately 100ppm.

(Comparative Example 2)

Comparative example 2 was performed in a manner similar to that of example 1 except that crystalline graphite was added. The content of the added crystalline graphite in the sintered body was 800ppm. The crystallinity of carbon was analyzed by using laser Raman spectrum. A peak was observed at $1580cm^{-1}$. Accordingly, it was confirmed that the carbon was highly crystalline.

The carbon content, brightness, transmittance and volume resistivity of each of the hot plates according to examples (Ex.) 1 to 4 and comparative examples(Comp. Ex.) 1 to 2 produced as described above were analyzed by the following methods, respectively. Further, the temperature at the heating face of the ceramic substrate when the temperature was increased to 300 °C was measured by using a thermoviewer (JTC-6100, manufactured by JEOL Ltd.,). Thereafter, a silicon wafer for measuring temperature on which a thermocouple was attached was set on the heating face, and the temperature of the silicon wafer was measured.

The results of the measurement of the carbon content, brightness etc. are shown in Table 1 below. The results of the measurement obtained by using a thermoviewer or a thermocouple are also shown in Table 1, as the difference in temperature between the highest and lowest temperatures.

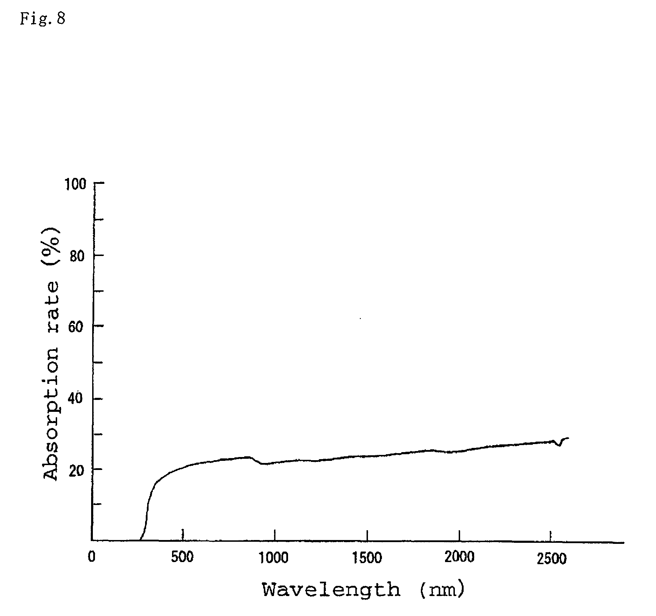

Further, Fig. 7 shows the transmittance at each wavelength observed in the sintered body (thickness: 0.5mm) of example 1. Fig. 8 shows the transmittance at each wavelength observed in the sintered body (thickness: 0.5mm) of comparative example 1.

Evaluation method

(1) Measurement of the carbon content

The carbon content of each plate-formed body made of aluminum nitride, manufactured in the above-mentioned examples and the comparative examples, was measured by pulverizing the plate-formed body, heating the pulverized sample at the temperature of 500 to 800 °C, collecting the $CO_x$ gases which generated from the heated sample and measuring the amount of the collected $CO_x$ gases.

(2) Measurement of light transmittance

A sintered body sample of 0.5mm thickness was cut out from each ceramic substrate obtained in the above-mentioned examples and comparative examples. Each of the obtained samples was set on a self-recording spectrophotometer ("U-4000 type" manufactured by Hitachi Seisakusho co.) which was capable of measuring transmittance of visual light of 240 to 2670nm, and the light transmittance (T/Tw) of each sample was measured.

(3) Measurement of volume resistivity

Each sintered body obtained in the above-mentioned examples and comparative examples was cut out to a sample having 10mm diameter and 3mm thickness by cutting work, whereby three terminals (a main electrode, a counter electrode and a guard electrode) were formed. A direct voltage was applied to the three terminals, and the current (I) which flowed through a digital electrometer after 1 minute-charge was measured, whereby the resistance (R) of the sample was obtained. The volume resistivity ($\rho$) was calculated from: the resistance (R); and the dimension of the sample according to the following calculation formula (1). Here, the temperature was 300°C.

Formula 1

$$\rho = \varepsilon/t \times R = S/t \times V/I \tag{1}$$

In the above-mentioned formula (1), t represents the thickness (mm) of the sample. S is given by the following formulas (2) and (3).

Formula 2

$$D_0 = (D_1 + D_2)/2 = 1.525\text{cm} \tag{2}$$

Formula 3

$$S = \pi D_0^2/4 = 1.83\text{cm}^2 \tag{3}$$

In the above-mentioned formulas (2) and (3), $r_1$ represents the radius of the main electrode, $r_2$ represents the inner size (radius) of the guard electrode, $r_3$ represents the outer size (radius) of the guard electrode, $D_1$ represents the diameter of the main electrode, $D_2$ represents the inner size (diameter) of the guard electrode, and $D_3$ represents the outer size (diameter) of the guard electrode. In the present embodiment, $2r_1 = D_1 = 1.45\text{cm}$, $2r_2 = D_2 = 1.60\text{cm}$, $2r_3 = D_3 = 2.00\text{cm}$.

Table 1

| | Carbon content (ppm) | Brightness | Transmittance (%) | Volume resistivity ($\Omega \cdot$cm) | Temperature difference (Thermoviewer) (°C) | Temperature difference (Silicon wafer) (°C) |
|---|---|---|---|---|---|---|
| Ex. 1 | 800 | N3.5 | 0.2 | $11 \times 10^{10}$ | 5 | 5 |
| Ex. 2 | 900 | N3.5 | 0.1 | $10 \times 10^{10}$ | 6 | 6 |
| Ex. 3 | 400 | N3.5 | 5.0 | $13 \times 10^{10}$ | 7 | 5 |
| Ex. 4 | 1800 | N3.5 | 0 | $9 \times 10^{10}$ | 6 | 6 |
| Comp. Ex. 1 | 100 | N7.0 | 28 | $18 \times 10^{10}$ | 12 | 6 |
| Comp. Ex. 2 | 800 | N3.5 | 15 | $2 \times 10^{10}$ | 11 | 6 |

As is obvious from the graphs shown in Figs. 7 and 8, the sintered body according to example 1 hardly has the absorbance of the wavelength in the infrared region, while the sintered body according to comparative example 1 exhibits a quite a high absorption rate of approximately 20% of the wavelength in the infrared region.
Further, as is obvious from Table 1 mentioned above, the temperature at the heating face can be accurately measured by a thermoviewer if the transmittance of infrared ray (2500nm) was reduced to not more than 10%.

Industrial Applicability

As described above, in the hot plate according to the present invention, the infrared ray transmittance of the ceramic substrate is not more than 10%, this is low. As a result, the temperature at the heating face of the ceramic substrate can be accurately measured by a thermoviewer. Further, in the hot plate according to the present invention, as the ceramic substrate thereof is sufficiently blackened so as to have a brightness of not more than N6, high radiation heat can be obtained.

**Claims**

1. A hot plate comprising a ceramic substrate and a conductor layer formed on a surface of said ceramic substrate or inside said ceramic substrate,
   wherein a transmittance of an infrared ray wavelength, of said ceramic substrate, is 0% or not more than 10%.

2. The hot plate according to claim 1,
   wherein a brightness, based on JIS Z 8721, of said ceramic substrate is not more than N6.

3. The hot plate according to claim 1 or 2,
   wherein said infrared ray wavelength is 2500nm.

Fig. 1

Fig. 2

Fig. 3

Fig.4

Fig. 5

(a)

(b)

(c)

(d)

Fig. 6

(a)

(b)

(c)

(d)

Fig. 7

Fig.8

## INTERNATIONAL SEARCH REPORT

| International application No. |
| --- |
| PCT/JP01/05139 |

A. CLASSIFICATION OF SUBJECT MATTER
Int.Cl$^7$   H01L21/02, H05B3/10, H05B3/16, H05B3/18, H05B3/20, 328, H01L21/66

According to International Patent Classification (IPC) or to both national classification and IPC

B. FIELDS SEARCHED

Minimum documentation searched (classification system followed by classification symbols)
Int.Cl$^7$   H01L21/02, H05B3/10, H05B3/16, H05B3/18, H05B3/20, 328, H01L21/66,
         C04B35/00, H01L21/68

Documentation searched other than minimum documentation to the extent that such documents are included in the fields searched
Jitsuyo Shinan Koho        1926-1996    Toroku Jitsuyo Shinan Koho   1994-2001
Kokai Jitsuyo Shinan Koho  1971-2001    Jitsuyo Shinan Toroku Koho   1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 9-48668 A (NGK Insulators, Ltd.),<br>18 February, 1997 (18.02.97),<br>Full text; Figs. 1 to 7<br>& DE 69610673 T      & EP 757023 A2<br>& JP 9-48669 A       & JP 9-110405 A<br>& US 5728635 A1      & KR 185528 B<br>& US 5908799 A1      & EP 992470 A | 1-3 |

☐ Further documents are listed in the continuation of Box C.   ☐ See patent family annex.

| | |
| --- | --- |
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>   08 August, 2001 (08.08.01) | Date of mailing of the international search report<br>   21 August, 2001 (21.08.01) |
| Name and mailing address of the ISA/<br>   Japanese Patent Office | Authorized officer |
| Facsimile No. | Telephone No. |

Form PCT/ISA/210 (second sheet) (July 1992)